(19) Europäisches Patentamt
European Patent Office
Office européen des brevets

(11) EP 2 093 882 A1

(12) **EUROPEAN PATENT APPLICATION**

(43) Date of publication:
26.08.2009 Bulletin 2009/35

(51) Int Cl.:
H03H 11/24 (2006.01)    H03G 1/00 (2006.01)

(21) Application number: 08003165.1

(22) Date of filing: 21.02.2008

(84) Designated Contracting States:
AT BE BG CH CY CZ DE DK EE ES FI FR GB GR HR HU IE IS IT LI LT LU LV MC MT NL NO PL PT RO SE SI SK TR
Designated Extension States:
AL BA MK RS

(71) Applicant: Siemens Milltronics Process Instruments Inc.
ON K9J 7B1 Peterborough (CA)

(72) Inventor: Burcea, George
Ajax ON L1T 4P6 (CA)

(74) Representative: Maier, Daniel Oliver
Siemens AG
Postfach 22 16 34
80506 München (DE)

(54) **Variable gain circuit**

(57) Variable gain circuits of the invention, both attenuators and amplifiers, are based upon a controllable variable resistance element which is provided by the Rds of a MOSFET (Q1). The resistance is controlled by a control signal Ictrl applied to the MOSFET drain. The MOSFET drain is maintained at a reference voltage Vref by use of an operational amplifier (A1) and a feedback loop. Use of the resistance arrangement of Fig. 1 in attenuator and amplifier circuits is described; in these circuits the arrangement of Fig. 1 allows the transfer and control functions to operate simultaneously without interfering with each other.

FIG 1

**Description**

This invention relates to variable gain circuits in the form of variable attenuators and variable gain amplifiers.

There are situations in which it is desired to provide a gain (attenuation or amplification) which varies in such a way that the transfer function conforms to a given analog signal. Currently, the parameters of variable gain attenuators and amplifiers are not accurate, or require the use of complex circuits. In some cases separate signal and calibration paths are used; however, this requires the use of separate components and relies upon component matching, which is never perfect.

A need exists to provide a variable gain circuit which can provide a high level of conformance while using standard, unmatched components.

The present invention provides a variable gain circuit comprising a signal input and a signal output connected by a transfer path, the transfer path including a variable resistance element which is controlled by a gain control signal to provide a desired gain; the gain control signal path being so arranged that gain control signals do not interfere with signals in the transfer path.

The use of a non-interfering control signal in the same network where the input signal is processed makes it possible to calibrate the non-linear (non-conforming) component and to process the input signal at the same time with the same component.

In preferred embodiments, the variable resistance element comprises a MOSFET source-drain path, and the reference control loop comprises a feedback loop connected to the MOSFET gate, and typically the feedback loop includes an operational amplifier having an output connected to the MOSFET gate and having inputs connected to a voltage reference and to the MOSFET drain.

The feedback loop preferably includes an RC filter. This has the benefit of making the feedback loop insensitive to high frequencies.

The gain control signal may suitably be a control current applied to the MOSFET drain, the control current being generated by a controlled current source or by a control voltage applied across a reference resistor.

Preferably the transfer path is AC coupled by means of input and output capacitors. This ensures separation of the transfer and control paths.

In an alternative form of the invention, the transfer path and the gain control signal path carry signals at different frequencies, and filters are provided for separating said signals.

The variable gain circuit according to the invention may be a variable attenuator. In one form of variable attenuator, the input signal is applied to the serial combination of a fixed resistor and said variable resistance element, and the output is taken from the junction of the fixed resistor and said variable resistance element.

Alternatively, the variable gain circuit according to the invention may be a variable gain amplifier. The input signal may be applied to a transistor in series with said variable resistance element; or the transfer path may comprise an operational amplifier, a coupling capacitor being provided between the transfer path and the variable resistance element.

Embodiments of the invention will now be described, by way of example, with reference to the drawings, in which:

Fig. 1             is a circuit diagram illustrating the principle of the invention;
Fig. 2             shows an embodiment of the invention incorporated in a variable attenuator; and
Figs. 3 and 4     illustrate embodiments of the invention incorporate din variable gain amplifiers.

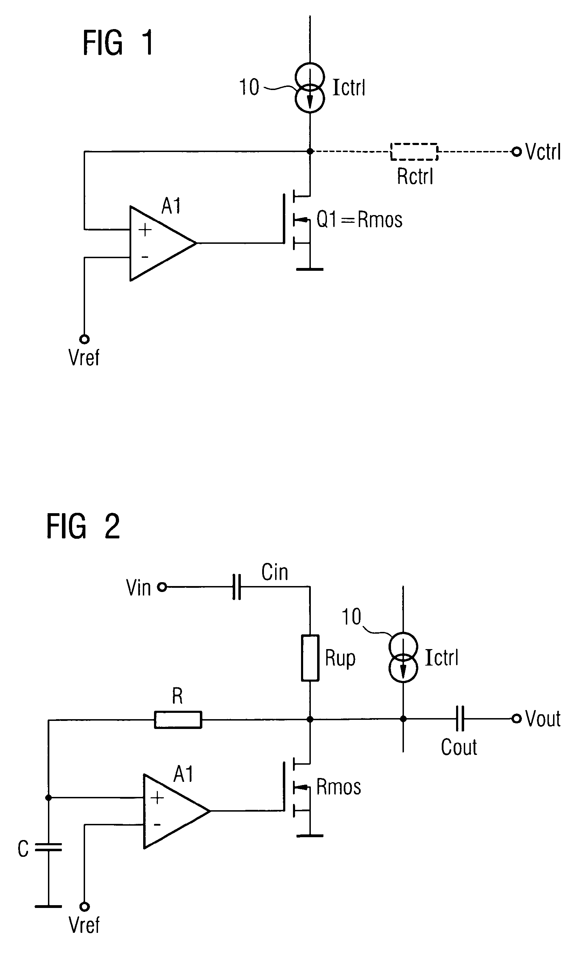

Referring to Fig. 1, a MOSFET Q1 acts as a conforming variable resistor as follows. The gate of Q1 is connected to the output of an operational amplifier A1. The inverting input of the operational amplifier A1 is connected to a reference voltage Vref, and the non-inverting input is connected to the drain of MOSFET Q1. This controls MOSFET Q1 in such a way that the drain potential is maintained at Vref.

The drain current of MOSFET Q1 is controlled at a desired current Ictrl by a controlled current source 10, or alternatively by applying a control voltage Vctrl across a reference resistor Rctrl. The drain-source resistance of MOSFET Q1 is given by

$$Rmos = Vref/Ictrl$$

Thus, by changing the control current Ictrl the resistance Rmos of MOSFET Q1 is changed accordingly. In this way, Rmos can be accurately modulated by the signal Ictrl.

With proper separation between signals, the conforming variable resistor presented in Fig. 1 can be used in various circuits, such as those shown in Figs. 2 to 4.

Fig. 2 shows a variable attenuator. The signal applied at Vin is divided between resistor Rup and Rmos, and Rmos is controlled by Ictrl. The transfer function is given by

$$Vout = Vin \times Rmos/(Rup + Rmos)$$

The feedback loop of the amplifier A1 contains an RC filter which makes this loop insensitive to high frequency. The signal path from Vin to Vout is AC coupled by means of capacitors Cin and Cout, which ensures that the control signal Ictrl and the input signal Vin do not interfere with each other.

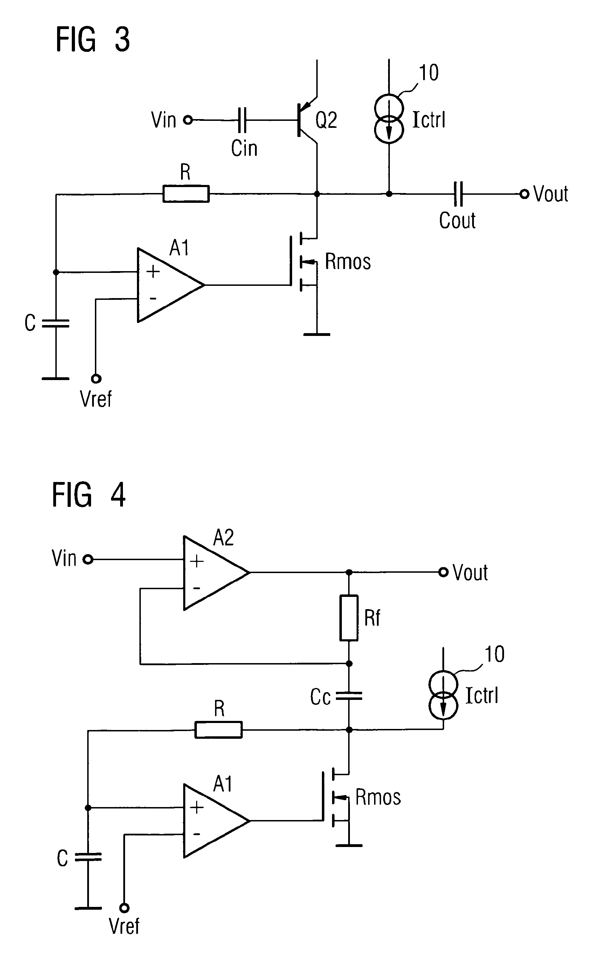

Fig. 3 shows one example of the invention applied to a variable gain amplifier in which amplification is provided by a bipolar transistor Q2. The gain of transistor Q2 is a function of its collector resistor, in this case Rmos which is controlled by control current Ictrl. Again, the Vin-Vout path is AC coupled by means of capacitors Cin and Cout.

In Fig. 4, variable amplification is provided by an operational amplifier A2. As Rmos is a 1/x function (Vref/Ictrl) and the gain of amplifier A2 is also a 1/x function, the gain of amplifier A2 is a linear function of Ictrl. In this example the input signal Vin and control signal Ictrl are non-interfering owing to separation by a coupling capacitor Cc.

All of the above embodiments permit the attenuator or amplifier to have a transfer function controlled by the control signal Ictrl to achieve a high level of conformance, without the use of complex circuits or specially chosen or matched components.

**Claims**

1.  A variable gain circuit comprising a signal input (Vin) and a signal output (Vout) connected by a transfer path, the transfer path including a variable resistance element (Q1) which is controlled by a gain control signal (Ictrl) to provide a desired gain; the gain control signal path being so arranged that gain control signals do not interfere with signals in the transfer path.

2.  The circuit of claim 1, in which the variable resistance element comprises a source-drain path of a MOSFET (Q1).

3.  The circuit of claim 2, including a reference signal source (10) providing a reference signal (Ictrl) across the MOSFET (Q1); the reference signal source (10) being controlled by a reference control loop which includes the MOSFET (Q1).

4.  The circuit of claim 3, in which the reference control loop comprises a feedback loop connected to the gate of the MOSFET (Q1).

5.  The circuit of claim 4, in which the feedback loop includes an operational amplifier (A1) having an output connected to the MOSFET (Q1) gate and having inputs connected to a voltage reference (Vref) and to the MOSFET (Q1) drain.

6.  The circuit of claim 4 or claim 5, in which the feedback loop includes a resistance-capacitance filter (R,C).

7.  The circuit of any of claims 4 to 6, in which the gain control signal is a control current (Ictrl) applied to the MOSFET (Q1) drain.

8.  The circuit of claim 7, in which the control current (Ictrl) is generated by a controlled current source (10).

9.  The circuit of claim 7, in which the control current (Ictrl) is generated by a control voltage (Vctrl) applied across a reference resistor (Rctrl).

10.  The circuit of any of claims 3 to 10, in which the transfer path is AC coupled by means of input and output capacitors (Cin, Cout).

11.  The circuit of claim 1 or claim 2, in which the transfer path and the gain control signal path carry signals at different frequencies (F1,F2), and filters (14,16) are provided for separating said signals.

12.  A variable gain circuit according to any preceding claim, being a variable attenuator.

13.  The variable attenuator of claim 12, in which the input signal is applied to the serial combination of a fixed resistor (Rup) and said variable resistance element (Q1), and the output is taken from the junction of the fixed resistor (Rup) and said variable resistance element (Q1).

**14.** A variable gain circuit according to any of claims 1 to 11, being a variable gain amplifier.

**15.** The variable gain amplifier of claim 14, in which the input signal is applied to a transistor (Q2) in series with said variable resistance element (Q1).

**16.** The variable gain amplifier of claim 14, in which the transfer path comprises an operational amplifier (A2), and a coupling capacitor (Cc) is provided between the transfer path and the variable resistance element (Q1).

FIG 1

FIG 2

FIG 3

FIG 4

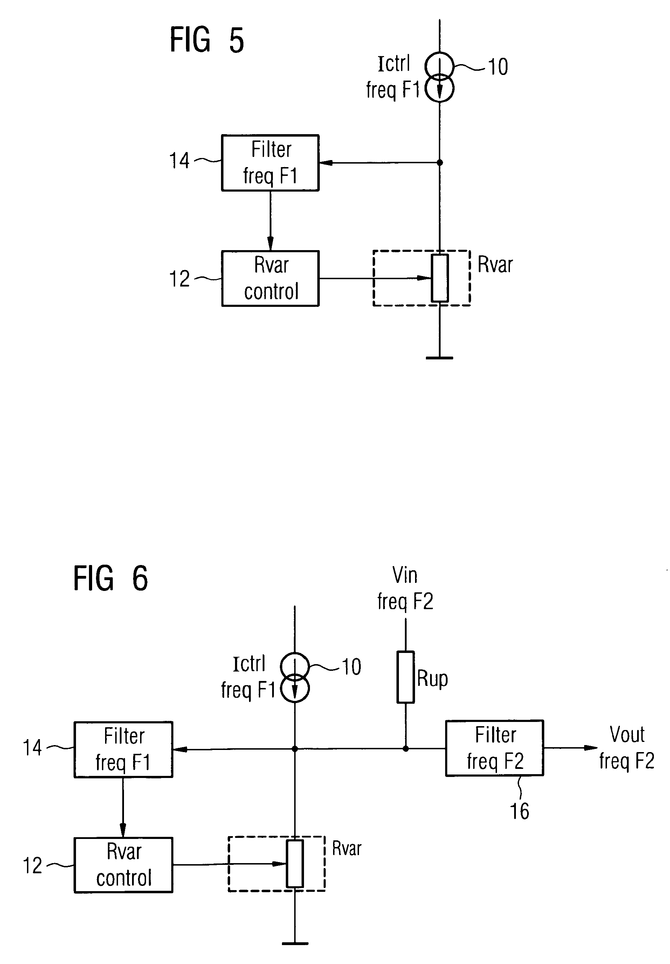

FIG 5

Ictrl
freq F1 ⊗ ⟋10

14 ⟋ ┌─────────┐
        │ Filter  │ ◄───────────●
        │ freq F1 │
        └─────────┘
             │
             ▼
12 ⟋ ┌─────────┐        ┌ ─ ─ ─ ┐
        │  Rvar   │─────────→│  ▯   │ Rvar
        │ control │        └ ─ ─ ─ ┘
        └─────────┘

FIG 6

                              Vin
                              freq F2

Ictrl                           │
freq F1 ⊗ ⟋10                 ▯ Rup

14 ⟋ ┌─────────┐                                    ┌─────────┐
        │ Filter  │ ◄──────────●──────────●──────────│ Filter  │──→ Vout
        │ freq F1 │                                    │ freq F2 │     freq F2
        └─────────┘                                    └─────────┘
             │                                              ⟋
             ▼                                             16
12 ⟋ ┌─────────┐        ┌ ─ ─ ─ ┐
        │  Rvar   │─────────→│  ▯   │ Rvar
        │ control │        └ ─ ─ ─ ┘
        └─────────┘

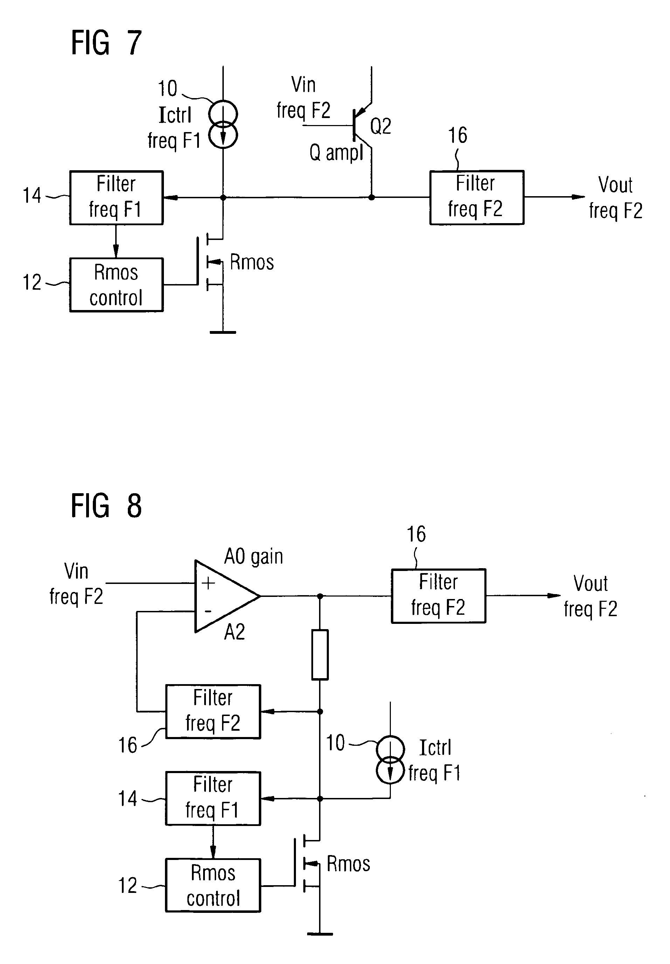

FIG 7

FIG 8

Europäisches Patentamt

European Patent Office

Office européen des brevets

**EUROPEAN SEARCH REPORT**

Application Number

EP 08 00 3165

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 4 937 466 A (OSTERKAMP JEFF B [US] ET AL) 26 June 1990 (1990-06-26) * column 4, lines 18-24; figure 1 * | 1-6, 10-15 | INV. H03H11/24 H03G1/00 |
| A | | 7-9 | |
| | ----- | | |
| X | EP 0 342 329 A (SIEMENS AG ALBIS [CH]) 23 November 1989 (1989-11-23) | 1-6, 10-15 | |
| A | * column 2, line 17 - column 4, line 20; figure 1 * | 7-9 | |
| | ----- | | |
| X | EP 0 708 526 A (SGS THOMSON MICROELECTRONICS [FR] ST MICROELECTRONICS SA [FR]) 24 April 1996 (1996-04-24) | 1-6, 10-15 | |
| A | * figures 1-3 * | 7-9 | |
| | ----- | | |

TECHNICAL FIELDS
SEARCHED     (IPC)

H03H
H03G

~~The present search report has been drawn up for all claims~~

| Place of search | Date of completion of the search | Examiner |
|---|---|---|
| Munich | 30 July 2008 | Fritzsche, H |

EPO FORM 1503 03.82 (P04C01)

Europäisches
Patentamt

European
Patent Office

Office européen
des brevets

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

see annex

☐ The present supplementary European search report has been drawn up for those parts of the European patent application which relate to the invention first mentioned in the claims (Rule 164 (1) EPC).

Europäisches Patentamt

European Patent Office

Office européen des brevets

**LACK OF UNITY OF INVENTION
SHEET B**

Application Number

EP 08 00 3165

The Search Division considers that the present European patentapplication does not comply with the requirements of unity of invention and relates to severalinventions or groups of inventions, namely:

1. claims: 1-15

   variable gain circuit with reference control loop including a variable resistance element being a MOSFET and in which the gain control signal is a control current applied to the MOSFET drain
   ---

2. claim: 16

   a variable gain circuit comprising a transferpath with a variable resistance element in which the transfer path comprises an operational amplifier , and a coupling capacitor is provided between the transferpath and the variable resistance element.
   ---

**ANNEX TO THE EUROPEAN SEARCH REPORT
ON EUROPEAN PATENT APPLICATION NO.**

EP 08 00 3165

This annex lists the patent family members relating to the patent documents cited in the above-mentioned European search report.
The members are as contained in the European Patent Office EDP file on
The European Patent Office is in no way liable for these particulars which are merely given for the purpose of information.

30-07-2008

| Patent document cited in search report | | Publication date | Patent family member(s) | | Publication date |
|---|---|---|---|---|---|
| US 4937466 | A | 26-06-1990 | NONE | | |
| EP 0342329 | A | 23-11-1989 | CH | 675181 A5 | 31-08-1990 |
| | | | DE | 58905102 D1 | 09-09-1993 |
| | | | US | 5087899 A | 11-02-1992 |
| EP 0708526 | A | 24-04-1996 | DE | 69516627 D1 | 08-06-2000 |
| | | | DE | 69516627 T2 | 25-01-2001 |
| | | | FR | 2725856 A1 | 19-04-1996 |

EPO FORM P0459

For more details about this annex : see Official Journal of the European Patent Office, No. 12/82